## Europäisches Patentamt
## European Patent Office
## Office européen des brevets

(11) Veröffentlichungsnummer: **0 007 561**
A1

# EUROPÄISCHE PATENTANMELDUNG

(21) Anmeldenummer: 79102500.0

(22) Anmeldetag: 17.07.79

(51) Int. Cl.³: **H 03 K 17/13**
**H 01 H 47/00**
**//H03K17/78**

(30) Priorität: 25.07.78 DE 2832590

(43) Veröffentlichungstag der Anmeldung:
06.02.80 Patentblatt 80/3

(84) Benannte Vertragsstaaten:
CH FR GB IT SE

(71) Anmelder: SIEMENS AKTIENGESELLSCHAFT Berlin und München
Postfach 261
D-8000 München 22(DE)

(72) Erfinder: Havel, Jiri, Dipl.-Ing.
D-8421 Rappersdorf, Nr 2(DE)

(72) Erfinder: Schicketanz, Dieter, Dr. phil. Dipl.-Ing.
Sintpertstrasse 13
D-8000 München 90(DE)

(72) Erfinder: Stut, Hans
Maistrasse 18
D-8031 Gröbenzell(DE)

(54) Kontaktloses Relais.

(57) Die Erfindung bezieht sich auf kontaktlose Relais, die im oder in der Nähe des Nulldurchgangs schalten. Diejenige Spannung, bei der das Relais nicht mehr schalten darf, wird durch eine in der Steuerleitung eines Transistors (9) liegende Zenerdiode (15) bestimmt. Der Transistor (9) wird damit bei einer definierten, von den Toleranzen der verwendeten Bauelemente unabhängigen Spannung eingeschaltet und schließt die Basis-Katodenstrecke eines Thyristors (8) kurz. Dieser kann dann so lange nicht gezündet werden, wie die zu schaltende Wechselspannung die Zenerspannung übersteigt. Die Erfindung ist zum kontaktlosen Schalten von Wechselspannungen brauchbar.

EP 0 007 561 A1

SIEMENS AKTIENGESELLSCHAFT          Unser Zeichen

Berlin und München                  VPA

                                78 P 1 1 2 9 EUR

### Kontaktloses Relais

Die vorliegende Erfindung bezieht sich auf ein kontaktloses Relais mit einer Vollweg-Gleichrichterbrücke, deren Gleichspannungsanschlüsse mit der Katode beziehungsweise der Anode eines Thyristors verbunden sind, mit zwei Transistoren, deren Laststrecken der Basis-Katodenstrecke des Thyristors parallelgeschaltet sind, wobei der Steueranschluß des ersten Transistors über einen Widerstand mit der Anode und über die Laststrecke eines Steuertransistors mit der Katode des Thyristors verbunden ist und wobei der Steueranschluß des zweiten Transistors über je einen Widerstand mit der Anode beziehungsweise der Katode des Thyristors verbunden ist.

Ein kontaktloses Relais dieser Art ist bereits beschrieben worden. Es ist erwünscht, daß ein solches Relais durch Anlegen eines Steuersignals nur in der Nähe des Nulldurchgangs der Wechselspannung schaltet. Wird ein Steuersignal angelegt und ist die Wechselspannung von Null nur wenig verschieden, so wird der genannte Thyristor gezündet, der seinerseits je nach Phasenlage der Wechselspannung den Zündstrom für einen von zwei antiparallel geschalteten Thyristoren oder für einen Zweirichtungsthyristor (Triac) liefert. Um eine Zündung des genannten Thyristors dann zu verhindern, wenn die Wechselspannung stark von Null verschieden ist, ist der Basis-Katodenstrecke des Thyristors die Laststrecke eines Transistors parallel geschaltet. Der Steuereingang des Transistors liegt am Abgriff eines mit der gleichgerichteten Wechselspannung gespeisten Spannungsteilers. Wenn die gleichgerichtete Wechselspannung ansteigt, wird der Transistor leitend, die Basis-Katodenstrecke des Thyristors wird kurzgeschlossen und eine Zündung des Thyristors und ein Einschalten des ganzen Relais ist damit nicht möglich.

Der Basis-Katodenstrecke des Thyristors ist die Laststrecke eines zweiten Transistors parallelgeschaltet, der seinerseits von einem Steuertransistor gesteuert wird. Solange der Steuertransistor nicht durch eine Steuerspannung leitend gesteuert wird, ist der zweite Transistor leitend und verhindert eine Zündung des Thyristors unabhängig vom Augenblickswert der gleichgerichteten Wechselspannung.

Die Größe der gleichgerichteten Wechselspannung, bei der der erste Transistor leitend gesteuert wird, hängt bei festgelegter Dimensionierung der Schaltung von den Eigenschaften des ersten Transistors ab. Da diese Eigenschaften unvermeidbaren Streuungen unterworfen sind, so ist auch die Einschaltspannung des ersten Transistors (Nullspannungsschalter) von Relais zu Relais verschieden.

Der Erfindung liegt die Aufgabe zugrunde, eine Schaltungsanordnung der genannten Art so weiterzubilden, daß der Nullspannungsschalter im wesentlichen von Exemplarstreuungen unabhängig einschaltet.

Die Erfindung ist dadurch gekennzeichnet, daß dem mit der Anode des Thyristors und dem Steueranschluß des zweiten Transistors verbundenen Widerstand eine Zenerdiode in Reihe geschaltet ist.

Der Basis-Katodenstrecke des Thyristors kann dabei eine Diode in Reihe geschaltet sein.

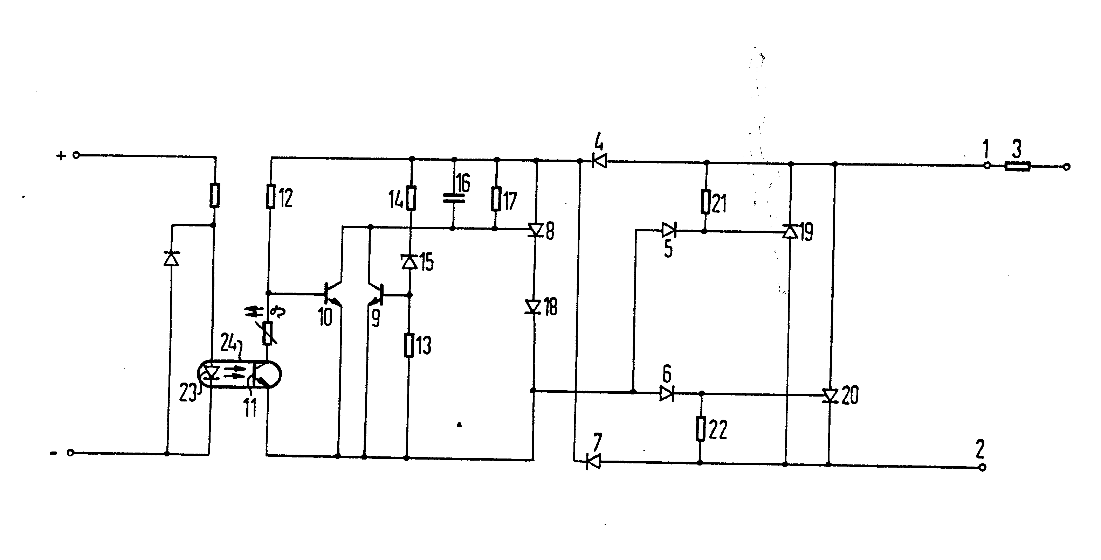

Ein Ausführungsbeispiel der Erfindung wird in Verbindung mit der Figur beschrieben:

Das kontaktlose Relais hat zwei Eingangsklemmen 1, 2 und liegt über eine Last 3 an einer Wechselspannung. Mit den Eingangsklemmen 1, 2 ist über Widerstände 21, 22 eine Vollweg-Gleichrichterbrücke mit den Dioden 4, 5, 6, 7 verbunden. Mit den Ausgangsklemmen der Gleichrichterbrücke ist die Anode beziehungsweise die Katode eines Thyristors 8 verbunden. Der Basis-Katodenstrecke des Thyristors 8 sind die Kollektor-Emitterstrecken eines ersten Transistors 9 und eines zweiten Transistors 10 parallelgeschaltet. Der Basisanschluß des Transistors 9 ist über einen Widerstand 13 mit der Katode des Thyristors 8 und über eine Zenerdiode 15 und einen mit dieser in Reihe geschalteten Widerstand 14 mit der Anode des Thyristors 8 verbunden. Der Basisanschluß des zweiten Transistors 10 ist über einen Widerstand 12 mit der Anode und über die Laststrecke eines Steuertransistors 11 mit der Katode des Thyristors 8 verbunden. Die Kollektoren der Transistoren 9, 10 sind über eine Parallelschaltung aus einem Kondensator 16 und einem Widerstand 17 ebenfalls mit der Anode des Thyristors 8 verbunden.

Zur Erläuterung der Funktionsweise des kontaktlosen Relais wird davon ausgegangen, daß der Augenblickswert
der gleichgerichteten Wechselspannung nur so wenig von
Null verschieden ist, daß ein Schalten des kontaktlosen
Relais erlaubt ist. Die Einsatzspannung des als Nullschalters arbeitenden Transistors 9 wird durch die Zenerdiode 15 bestimmt. Solange die Zenerspannung nicht
erreicht wird, ist der Transistor 9 gesperrt. Wird der
Steuertransistor 11 durch eine äußere Steuergröße leitend gesteuert, so wird der Transistor 10 ebenfalls gesperrt und der Basisanschluß des Thyristors 8 erhält
über die RC-Schaltung 16, 17 einen starken Steuerstrom
und zündet. Der durch den Thyristor 8 fließende Laststrom fließt dann über die Dioden 5 und 6 der Gleichrichterbrücke zu den Steueranschlüssen von im Wechselspannungskreis liegenden, antiparallel geschalteten Thyristoren 19, 20. Je nachdem, an welcher der Klemmen 1, 2
die Wechselspannung gerade positive Werte hat, wird entweder der Thyristor 19 oder der Thyristor 20 leitend gesteuert. Das kontaktlose Relais ist damit eingeschaltet,
und die Last 3 wird vom Strom durchflossen.

Als zweiter Fall wird angenommen, daß der Augenblickswert der Wechselspannung bereits so hoch ist, daß das
kontaktlose Relais nicht mehr schalten darf. Diese Spannung wird durch die Zenerspannung der Zenerdiode 5 bestimmt. Wird die Zenerspannung überschritten, so wird
der Transistor 9 angesteuert. Die Kollektor-Emitterstrecke des Transistors 9 schließt damit die Basis-Katodenstrecke des Thyristors 8 kurz, und eine Zündung
des Thyristors ist nicht mehr möglich. Eine Zündung des

- 5 -    VPA 78 P 1 1 2 9 EUR

Thyristors ist auch dann nicht möglich, wenn auf den Eingang des kontaktlosen Relais eine Steuerspannung gegeben wird, da beide Transistoren 9 und 10 einander parallel geschaltet sind. Diejenige Spannung, bei der das kontaktlose Relais nicht mehr schalten darf, ist damit weitgehend unabhängig von Exemplarstreuungen des als Nullpunktschalter verwendeten Transistors 9. Damit wird ein besser definiertes Einschaltverhalten erreicht.

Da die Freiwerdezeit des Thyristors 8 Exemplarstreuungen unterworfen ist, kann es vorkommen, daß der Thyristor 8 selbst im Nulldurchgang der gleichgerichteten Spannung nicht gelöscht wird, wenn die zur Verfügung stehende Freiwerdezeit zu klein ist. Es empfiehlt sich in solchen Fällen, in die Katodenleitung des Thyristors 8 eine Diode 18 einzuschalten. Damit wird die Schleusenspannung der aus dem Thyristor 8 und der Diode 18 gebildeten Gleichrichteranordnung erhöht, zum Beispiel verdoppelt, und der Thyristor 8 wird sicher gelöscht. Mit dieser Maßnahme wird also eine Verbesserung des Ausschaltverhaltens erreicht.

Dem Steuertransistor 11 kann ein Kaltleiter 25 in Reihe geschaltet sein. Damit wird das Relais vor Übertemperaturauswirkungen geschützt.

Die Widerstände 12, 14 können zum Beispiel 560 kOhm, der Widerstand 17 100 kOhm, der Widerstand 13 22 kOhm betragen. Der Kondensator 16 kann zum Beispiel 100 pF und die Zenerdiode 15 eine Zenerspannung von 9 V haben. Die Widerstände 21, 22 können zum Beispiel bei 47 Ohm liegen.

2 Patentansprüche

1 Figur

0007561

## Patentansprüche

1. Kontaktloses Relais mit einer Vollweg-Gleichrichterbrücke, deren Gleichspannungsanschlüsse mit der Katode beziehungsweise der Anode eines Thyristors verbunden sind, mit zwei Transistoren, deren Laststrecken der Basis-Katodenstrecke des Thyristors parallelgeschaltet sind, wobei der Steueranschluß des ersten Transistors über einen Widerstand mit der Anode und über die Laststrecke eines Steuertransistors mit der Katode des Thyristors verbunden ist und wobei der Steueranschluß des zweiten Transistors über je einen Widerstand mit der Anode beziehungsweise der Katode des Thyristors verbunden ist, d a d u r c h   g e k e n n z e i c h n e t , daß dem mit der Anode des Thyristors (8) und dem Steueranschluß des zweiten Transistors (9) verbundenen Widerstand (14) eine Zenerdiode (15) in Reihe geschaltet ist.

2. Kontaktloses Relais nach Anspruch 1,   d a d u r c h   g e k e n n z e i c h n e t ,   daß der Basis-Katodenstrecke des Thyristors (8) eine Diode (18) in Reihe geschaltet ist.

| | Europäisches Patentamt | **EUROPÄISCHER RECHERCHENBERICHT** | Nummer der Anmeldung EP 79 10 2500 |

## EINSCHLÄGIGE DOKUMENTE

| Kategorie | Kennzeichnung des Dokuments mit Angabe, soweit erforderlich, der maßgeblichen Teile | betrifft Anspruch | KLASSIFIKATION DER ANMELDUNG (Int.Cl. 3) |
|---|---|---|---|
| X | JEE JOURNAL OF ELECTRONIC ENGINEERING, Nr. 116, August 1976, Seiten 26-29 Tokyo, JP. H. INABA: "SSRs Fill Gap Left by EMRs" <br><br> * Figur 2, Company A, Company B; Seite 26, rechte Spalte, Zeile 10 - Seite 28, linke Spalte, Zeile 7 * <br><br> -- | 1,2 | H 03 K 17/13 H 01 H 47/00// H 03 K 17/78 |
| | ELECTRONIC ENGINEERING, Vol. 45, Nr. 547, September 1973, Seiten 89-92 London, G.B. G.C. RIDDLE: "Bright future for opto-electronics" <br><br> * Figur 1; Seite 92, Mittelspalte, Zeilen 26-45 * <br><br> -- | 1 | RECHERCHIERTE SACHGEBIETE (Int. Cl. 3) <br><br> H 03 K 17/13 |
| | ELECTRONICS, Vol. 49, Nr. 14, 8. Juli 1976, Seiten 101-105 New York, U.S.A. A.Q. MOWATT: "RFI generation is a factor when selecting ac-switching relays" <br><br> * Figur 6; Seite 102, rechte Spalte, Zeile 8 - Seite 104, linke Spalte, Zeile 5 * <br><br> -- | 1,2 | |
| A | US - A - 3 723 769 (COLLINS) <br><br> * Figur 2; Spalte 2, Zeile 42 - Spalte 4, Zeile 30 * <br><br> ---- | 1 | KATEGORIE DER GENANNTEN DOKUMENTE <br><br> X: von besonderer Bedeutung <br> A: technologischer Hintergrund <br> O: nichtschriftliche Offenbarung <br> P: Zwischenliteratur <br> T: der Erfindung zugrunde liegende Theorien oder Grundsätze <br> E: kollidierende Anmeldung <br> D: in der Anmeldung angeführtes Dokument <br> L: aus andern Gründen angeführtes Dokument <br> &: Mitglied der gleichen Patentfamilie, übereinstimmendes Dokument |

Der vorliegende Recherchenbericht wurde für alle Patentansprüche erstellt

| Recherchenort | Abschlußdatum der Recherche | Prüfer |
|---|---|---|
| Den Haag | 18-10-1979 | LEDRUT |